# EUROPEAN PATENT APPLICATION

(11) **EP 2 277 697 A1**
(43) Date of publication of application: **26.01.2011**
(21) Application number: 09746597.5
(22) Date of filing: 12.05.2009
(51) Int. Cl.: B32B 27/00, B32B 9/00, B32B 15/08, H05B 33/04, H05B 33/14

(54) **GAS BARRIER LAMINATED FILM FOR ORGANIC DEVICES**

(30) Priority: 16.05.2008 JP 2008129990
(71) Applicant: Mitsubishi Plastics, Inc., Tokyo 103-0021 (JP)
(72) Inventor: YOSHIDA, Shigenobu, Ushiku-shi Ibaraki 300-1201 (JP); OKAWARA, Chiharu, Ushiku-shi Ibaraki 300-1201 (JP); MATSUI, Tsutomu, Nagahama-shi Shiga 526-8660 (JP)
(74) Representative: Gille Hrabal Struck Neidlein Prop Roos
(86) International application number: PCT/JP2009/058857
(87) International publication number: WO 2009/139391

(57) **Abstract**

[problems]

A gas-barrier laminated film is provided that has considerably excellent gas-barrier property and has excellent capability for an organic device.

[Means for Solution]

A gas-barrier laminated film for an organic device, containing a plurality of gas-barrier laminates each containing a substrate film having on at least one surface thereof at least two layers of inorganic thin film layers, the plurality of gas-barrier laminates being laminated through an adhesive layer, wherein the at least two layers of inorganic thin film layers contain two or more inorganic thin film layers that are formed in contact with each other, the gas-barrier laminates are laminated with a surface on a side of the substrate film of the gas-barrier laminate facing a surface on a side of the inorganic thin film layer thereof, and the adhesive layer contains an epoxy adhesive having at least one of a m-xylenediamine skeleton, a p-xylenediamine skeleton and a bisphenol skeleton.

## Description

### [Technical Field]

The present invention relates to a gas-barrier laminated film that has excellent gas-barrier property and has excellent capability as one for an organic device.

### [Background Art]

A gas-barrier plastic film containing a plastic film as a substrate having formed on the surface thereof an inorganic thin film, such as silicon oxide, aluminum oxide and magnesium oxide, has been widely used as packaging of a product that is necessarily shielded from water vapor and various kinds of gas, such as oxygen, for example packaging for preventing food and industrial goods, medical goods and the like from denaturing. In recent years, in addition to the application of packaging, the gas-barrier plastic film is receiving attention as new applications including industrial materials, such as a liquid crystal display device, a solar cell, an electromagnetic shield, a touch-sensitive panel, an organic device, a color filter and a vacuum thermal insulation material.
With respect to the gas-barrier plastic film having an inorganic thin film formed thereon, some improvements have been investigated for various purposes, and examples of the improvements include, from the standpoint of the transparency and the gas-barrier property a gas-barrier films containing a plastic film having laminated sequentially thereon a metal oxide layer, a resin layer and a metal oxide layer, the film having a total light transmittance of 85% or more, and decreasing rates of an oxygen permeability and a water vapor permeability of both 20% or less after immersing in ethyl acetate for 1 minute, and the oxygen permeability and the water vapor permeability being both 1 or less (see Patent Document 1), and for preventing and suppressing a metal oxide from being broken, a barrier film containing a transparent plastic film having laminated sequentially and alternately thereon metal oxide layers and organic material layers, in which the difference in solubility factor between the organic material layer and the transparent plastic film adjacent to each other with the metal oxide layer intervening therebetween is 1.0 or more (see Patent Document 2).

However, these films are improved in capability to some extent, but they are still insufficient, for example, in gas-barrier property and the adhesion strength between the constitutional layers of the laminated film, and improvements thereof are demanded.
Examples of the improvements also include, for enhancing the water vapor barrier property, a laminated product of a transparent resin layer, an oxide thin film layer and a hygroscopic resin layer laminated through adhesive layers (see Patent Document 3), and for enhancing the heat resistance and the gas-barrier property, a laminated product of two or more resin layers laminated with an organic-inorganic hybrid layer obtained by a sol-gel method intervening therebetween (see Patent Document 4).
In the case where a gas-barrier film is laminated through an adhesive layer as in these cases, when the adhesive layer is cured by heating or the like, carbon dioxide gas is formed due to water content in the substrate or the air during or after processing and causes bubbles or whitening due to bubbling between the laminated layers of the gas-barrier film, which causes an appearance problem and promotes decrease of the gas-barrier property and the lamination strength.
In view of the problems, Patent Document 5 pays attention to the composition of the adhesive, and discloses a film that removes the whitening due to bubbling and the bubbles entrained, by suppressing the influence of water contend.
However, the films attains improvements of the target capabilities to some extent, but they are still insufficient, for example, in gas-barrier property and lamination strength (interlayer adhesiveness) of the laminated product, and in particular, there is a demand of improvement thereof in the field of an organic device, in which the film is used by joining with a hygroscopic layer and is demanded to have considerably high gas-barrier property.

### [Prior Art Documents]

### [Patent Documents]

[Patent Document 1] JP-A-2003-71968
[Patent Document 2] JP-A-2003-231202
[Patent Document 3] JP-A-2003-249349
[Patent Document 4] JP-A-2004-136466
[Patent Document 5] JP-A-2006-51751

### [Summary of the Invention]

### [Problems to be solved by the Invention]

An object to be achieved by the present invention is to provide a gas-barrier laminated film for an organic device, which is a laminated film that exhibits considerably excellent gas-barrier property and has excellent adhesion strength among the constitutional layers, that is considerably decreased in occurrence of bubbles and foreign matters between the gas-barrier laminates and is excellent in gas-barrier property and adhesiveness among the layers, and to provide a method for producing the same.

The present inventors have found that the object is achieved by a laminated film having a particular layer structure and an adhesive layer, and the present invention relates to:
[1] a gas-barrier laminated film for an organic device, containing plural gas-barrier laminates each containing a substrate film having on at least one surface thereof at least two layers of inorganic thin film layers, the plural gas-barrier laminates being laminated through an adhesive layer, wherein the at least two layers of inorganic thin film layers contain two or more inorganic thin film layers that are formed in contact with each other, the gas-barrier laminates are laminated with a surface on a side of the substrate film of the gas-barrier laminate facing a surface on a side of the inorganic thin film layer thereof, and the adhesive layer contains an epoxy adhesive having at least one of a m-xylenediamine skeleton, a p-xylenediamine skeleton and a bisphenol skeleton, and

[2] a method for producing a gas-barrier laminated film for an organic device, containing:
   (1) a step of providing a gas-barrier laminate containing a substrate film having on at least one surface thereof at least two layers of inorganic thin film layers containing two or more inorganic thin film layers that are laminated in contact with each other,
   (2) a step of laminating the plural gas-barrier laminates with a surface on a side of the substrate film of the gas-barrier laminate facing a surface on a side of the inorganic thin film layer thereof, through an adhesive layer containing an epoxy adhesive having at least one of a m-xylenediamine skeleton, a p-xylenediamine skeleton and a bisphenol skeleton, to provide a gas-barrier laminated film, and
   (3) a step of, after laminating or simultaneously with laminating the gas-barrier laminates in the step (2), heating the laminates in a vacuum atmosphere of 1,000 Pa or less, or radiating an active energy ray on the laminates.

### [Advantages of the Invention]

The present invention provides a gas-barrier laminated film suitable for an organic device, which is a gas-barrier laminated film that exhibits considerably excellent gas-barrier property and has excellent adhesion strength among the constitutional layers, that is considerably decreased in occurrence of bubbles and foreign matters between the gas-barrier laminates and is excellent in gas-barrier property and adhesiveness among the layers.

### [Mode for carrying out the Invention]

The gas-barrier laminated film of the present invention necessarily contains plural gas-barrier laminates, each of which contains a substrate film having on at least one surface thereof at least two layers of inorganic thin film layers.

### Substrate Film

The substrate films of the gas-barrier laminate is preferably a thermoplastic polymer film from the standpoint of the flexibility and the productivity, and the material used therefor may be any resin that is ordinarily used for a packaging material without particular limitation. Specific examples thereof include polyolefin, such as a homopolymer and a copolymer of ethylene, propylene, butene and the like, amorphous polyolefin, such as cyclic polyolefin; polyester, such as polyethylene terephthalate and polyethylene- 2,6- naphthalate, a polyamide, such as nylon 6, nylon 66, nylon 12 and a copolymer nylon, an ethylene-vinyl acetate copolymer partial hydrolysate (EVOH), polyimide, polyether imide, polysulfone, polyether sulfone, polyether ether ketone, polycarbonate, polyvinyl butyral, polyarylate, a fluorine resin, an acrylate resin and a biodegradable resin. Among these, polyester, polyamide and polyolefin are preferred from the standpoint of the film property, cost and the like. Among these, polyethylene terephthalate and polyethylene naphthalate are particularly preferred from the standpoint of the film property.
The substrate film may contain a known additive, such as an antistatic agent, a light shielding agent, an ultraviolet ray absorbent, a plasticizer, a lubricant, a filler, a colorant, a stabilizer, a lubricating agent, a crosslinking agent, an antiblocking agent and an antioxidant.

A thermoplastic polymer film as the substrate film is formed by molding the aforementioned raw material and may be unstretched or stretched upon using as the substrate. Another plastic substrate may be laminated therewith. The substrate film may be produced by a known method, and for examples, an unstretched film, which is substantially amorphous and is not oriented, may be produced in such a manner that a raw material resin is melted and extruded through a circular die or a T-die with an extruder, followed by quenching. A single layer film with a single resin, a multilayer film with a single resin and a multilayer film with plural resins may be produced by using a multilayer die.
A film stretched in at least one direction may be produced by stretching the unstretched film in the machine direction longitudinal direction) of the film or the direction perpendicular to the machine direction (transversal direction) of the film by a known method, such as uniaxial stretching, sequential biaxial tenter stretching, simultaneous biaxial tenter stretching and simultaneous biaxial tubular stretching. The stretching ratio may be arbitrarily determined and is preferably such a value that provides a thermal contraction rate of from 0.01 to 5%, and more preferably from 0.01 to 2%, at 150°C.
Among the films, a biaxially stretched polyethylene terephthalate film, a biaxially stretched polyethylene naphthalate film and a polyethylene terephthalate-polyethylene naphthalate co-extruded biaxially stretched film are preferred from the standpoint of the film property

The thickness of the substrate film may be generally selected from a range of from 5 to 500 µm, and preferably from a range of from 10 to 200 µm, depending on purposes from the standpoint of the mechanical strength, the flexibility, the transparency and, the like as the substrate of the gas-barrier laminated film of the present invention, and the substrate film may include a sheet-like product having a large thickness. The width and the length of the film are not particularly limited and may be appropriately determined depending on purposes.
In the case where an anchor coating layer is provided on the substrate film, the film may be subjected to a surface treatment, such as a chemical treatment and a discharge treatment, before coating an anchor coating agent for enhancing the coating property and the adhesion property of the anchor coating agent.

### Anchor Coating

On the substrate film, an anchor coating layer is preferably formed by coating an anchor coating agent for enhancing the adhesion to the inorganic thin film. Examples of the anchor coating agent used include a solvent or aqueous polyester resin, an isocyanate resin, a urethane resin, an acrylic resin, a modified vinyl resin, a vinyl alcohol resin, a vinyl butyral resin, an ethylene-vinyl alcohol resin, a nitrocellulose resin, an oxazoline group-containing resin, a carbodiimide group-containing resin, a methylene group-containing resin, an epoxy group-containing resin, a modified styrene resin, a modified silicone resin and an alkyl titanate, which may be used solely or as a combination of two or more of them.
The anchor coating layer may contain a silane coupling agent, a titanium coupling agent, a light shielding agent, an ultraviolet ray absorbent, a stabilizer, a lubricant, an antiblocking agent, an antioxidant and the like, and a copolymer of the aforementioned resin with these agents may be used.

The method for forming the anchor coating layer may be selected from known coating methods. Examples the method used include coating methods using a reverse roll coater, a gravure coater, a rod coater, an air doctor coater, a spray and a brush. A vapor-deposited film may be immersed in a resin liquid to form the anchor coating layer. After coating, the solvent may be evaporated by a known drying method, such as heat drying, e.g., hot air drying at approximately from 80 to 200°C and heat roll drying, and infrared ray drying. The coated layer may be crosslinked by irradiation with an electron beam for enhancing the water resistance and the durability.
The anchor coating layer may be formed in the course of the production line of the substrate film (in-line) or may be formed after producing the substrate film (off-line).

The thickness of the anchor coating layer is preferably approximately from 0.005 to 5 µm, and more preferably from 0.01 to 1 µm. When the thickness is 5 µm or less, good sliding property is obtained, and release of the anchor coating layer due to internal stress therein may not occur. When the thickness is 0.005 µm or more, the uniform thickness can be favorably maintained.
The surface of the substrate film is flattened with the anchor coating, whereby particles forming the inorganic thin film are accumulated densely to form the inorganic thin film with a uniform thickness, thereby providing high gas-barrier property.

### Inorganic Thin Film

The gas-barrier laminate has at least two layers of inorganic thin film layers on at least one surface of the substrate film, preferably on one surface thereof. The method for forming the inorganic thin film include a vapor deposition method and a coating method, and a vapor deposition method is preferred since a uniform thin film having high gas-barrier property is obtained. The vapor deposition method includes a physical vapor deposition (PVD) method and a chemical vapor deposition (CVD) method. Examples of the physical vapor deposition method include vacuum vapor deposition, ion plating and sputtering, and examples of the chemical vapor deposition method include plasma CVD utilizing plasma, and a catalytic chemical vapor deposition (Cat-CVD) method, in which a raw material gas is catalytically pyrolyzed with a heated catalyst.
Examples of an inorganic substance constituting the inorganic thin film formed on at least one surface of the substrate film include silicon, aluminum, magnesium, zinc, tin, nickel, titanium and hydrogenated carbon, an oxide, a carbide and a nitride of them, and mixtures of them, and preferred examples thereof include silicon oxide, aluminum oxide and diamond-like carbon mainly containing hydrogenated carbon. Silicon oxide, silicon nitride, silicon oxynitride and aluminum oxide are particularly preferred since high gas-barrier property can be stably maintained.

A raw material gas capable of being used for chemical vapor deposition preferably contains at least one kind of gas, and for forming a silicon compound thin film, a first raw material gas containing silicon and, as a second raw material gas, ammonia, nitrogen, oxide, hydrogen or a rare gas, such as argon, are preferably used. Examples of the first raw material gas containing silicon include monosilane, tetramethoxysilane, methyltrimethoxysilane, dimethyldimethoxysilane, phenyltrimethoxysilane, diphenyldimethoxysilane, tetraethoxysilane, methyltriethoxysilane, dimethyldiethoxysilane, phenyltriethoxysilane, diphenyldiethoxysilane, hexyltrimethoxysilane, hexyltriethoxysilane, decyltrimethoxysilane, decyltriethoxysilane, trifluoropropyltrimethoxysilane, hexamethyldisiloxane and hexamethyldisilazane, which may be used solely or as a combination of two or more of them. The raw material gas may be in a liquid state or a gaseous state at room temperature, and a raw material liquid may be fed to an apparatus after vaporizing with a raw material vaporizer. In the catalytic chemical vapor deposition method, monosilane gas is preferred from the standpoint of deterioration of the heated catalyst, the reactivity and the reaction rate.
The thickness of the inorganic thin film is generally approximately from 0.1 to 500 nm, and preferably from 0.5 to 40 nm. When the thickness is in the range, sufficient gas-barrier property is obtained, and the inorganic thin film suffers no crack and release and is excellent in transparency.

For enhancing the gas-barrier property, it is effective to form the inorganic thin film with a multilayer structure. With respect to the formation of the multilayer structure of the inorganic thin film and the order of the thin films, thin films formed by one of vapor deposition, ion plating, sputtering, chemical vapor deposition and the like are accumulated, or in alternative, thin films formed by two or more different methods may be accumulated alternately.
The number of layers of the inorganic thin film may be at least two layers and is not limited as far as demanded gas-barrier property is obtained. The number of layers is preferably approximately from 2 to 10 layers, and more preferably from 2 to 5 layers, from the standpoint of the production cost and the stability upon forming the films.

Upon accumulating the inorganic thin films to form a multilayer structure in the present invention, the inorganic thin film having a multilayer structure preferably contains two or more layers of inorganic thin film layers that are formed in direct contact with each other, from the standpoint of the gas-barrier efficiency owing to enhancement of the affinity and the intimateness between the inorganic thin films. The inorganic thin film layers formed in direct contact with each other preferably contains approximately from 2 to 10 layers, more preferably from 2 to 5 layers, and further preferably from 2 or 3 layers. A resin layer may be provided between the two or more layers of inorganic thin film layers that are formed in contact with each other and another inorganic thin film. The resin layer may provide such effects as enhancement of adhesion between the inorganic thin films, dense accumulation of the particles, and infilling of gaps among the particles.
The components and the formation method of the resin layer may be those described for the anchor coating.

The resin layer preferably contains a silane coupling agent or a titanium coupling agent for enhancing the adhesion between the inorganic thin films.
Examples of the silane coupling agent include an epoxy group-containing silane coupling agent, such as β-(3,4-epoxycyclohexyl)ethyltrimethoxysilane, γ-glycidoxypropylmethyldiethoxysilane and γ-glycidoxypropyltrimethoxysilane, an amino group-containing silane coupling agent, such as γ-aminopropyltrimethoxysilane, N-β-(aminoethyl)-γ-aminopropylmethyldiethoxysilane, N-β-(aminoethyl)-γ-aminopropyltrimethoxysilane and N-β-(aminoethyl)-γ-aminopropyltriethoxysilane, and mixtures of them. Preferred examples of the silane coupling agent include γ-glycidoxypropyltrimethoxysilane and γ-aminopropyltrimethoxysilane. These compounds may be used solely or as a combination, of plural kinds of them. The silane coupling agent may be contained in a ratio of from 0.1 to 80% by mass, and preferably from 1 to 50% by mass, based on the resin constituting the resin layer from the standpoint of adhesion.

In the case where the resin layer is crosslinked with an energy ray, the resin constituting the resin layer may be any monomer that contains a functional group capable of being crosslinked with an ultraviolet ray or an electron beam without particular limitation, and a monomer having an acryloyl group, a methacryloyl group or an oxirane group is preferred. For example, the resin layer preferably contains mainly a polymer obtained by crosslinking a monomer having bifunctional or higher acryloyl groups or methacryloyl groups selected from epoxy (meth)acrylate, urethane (meth)acrylate, isocyanuric acid (meth)acrylate, pentaerythritol (meth)acrylate, trimethylolpropane (meth)acrylate, ethylene glycol (meth)acrylate, polyester (meth)acrylate and the like. The monomers having bifunctional or higher acryloyl groups or methacryloyl groups may be used as a mixture of two or more kinds of them or may be used with a monofunctional (meth)acrylate as a mixture. A monomer having an acryloyl group is most preferred from the standpoint of the curing rate.

In the case where vapor deposition polymerization is performed, a monomer or an oligomer capable of being polymerized through vacuum vapor deposition is polymerized and cured to form the resin layer. For example, a resin component containing a monomer, an oligomer or a mixture of them of an acrylic series capable of being polymerized is vaporized by heating and spray-coated on the surface of the inorganic thin film under vacuum, and is then polymerized and cured by heating or irradiation of an ultraviolet ray or an electron beam to form the resin layer. In the case where the curing is performed by irradiation of an ultraviolet ray, a resin coating material of an acrylic series or the like containing a photopolymerization initiator in addition to the resin component containing a monomer, an oligomer or a mixture of them may be used. Examples of the photopolymerization initiator include a benzoyl ether compound, a benzophenone compound, a xanthone compound and an acetophenone derivative, and preferred examples thereof include ones that are bonded to the monomer, the oligomer or the like to form a molecule for preventing volatilization from the resin layer after curing. The amount of the photopolymerization initiator used may be from 0.01 to 10% by weight, and preferably from 0.1 to 2% by weight, based on the monomer, the oligomer or the mixture of them.
The molecular weight of the monomer or the oligomer may be 10,000 or less, preferably 2,000 or less, and more preferably 1,000 or less. The viscosity thereof may be 500 cPs or less, and preferably 100 cPs or less, at ordinary temperature.
The thickness of the resin layer may be approximately from 0.5 nm to 1 µm, and is preferably from 0.5 to 20 nm, and particularly preferably from 0.5 to 5 nm, from the standpoint of the adhesion.

### Protective Layer

The gas-barrier laminate may have a protective layer for protecting the uppermost layer of the inorganic thin films. A resin for forming the protective layer may be any of solvent and aqueous and aqueous resins, and specific examples thereof include a polyester resin, a urethane resin, an acrylic resin, a polyvinyl alcohol resin, an ethylene-vinyl alcohol resin, a modified vinyl resin, a nitrocellulose resin, a silicone resin, an isocyanate resin, an epoxy resin, an oxazoline group-containing resin, a modified styrene resin, a modified silicone resin and an alkyl titanate resin, which may be used solely or as a combination of two or more of them. The protective layer may be a layer containing at least one of these resins having mixed therewith at least one kind of inorganic particles selected from silica sol, alumina sol, a particulate inorganic filler and a lamellar inorganic filler, or a layer formed of an inorganic particle-containing resin formed by polymerizing the raw material of the resin in the presence of the inorganic particles, for enhancing the barrier property, the abrasion property and the lubricating property.

The resin for forming the protective layer is preferably an aqueous resin from the standpoint of enhancement of the gas-barrier property of the inorganic thin film. Preferred examples of the aqueous resin include a vinyl alcohol resin and an ethylene-vinyl alcohol resin.
The protective layer may be a resin layer formed by coating an aqueous liquid containing polyvinyl alcohol and an ethylene-unsaturated carboxylic acid copolymer.
The thickness of the protective layer is preferably from 0.05 to 10 µm, and more preferably from 0.1 to 3 µm, from the standpoint of the printing property and the processability. The method for forming the protective layer may be appropriately selected from known coating methods. Examples the method used include coating methods using a reverse roll coater, a gravure coater, a rod coater, an air doctor coater, a spray, and a brush. A vapor-deposited film may be immersed in a resin liquid to form the protective layer. After coating, the water content may be evaporated by a known drying method, such as heat drying, e.g., hot air drying at approximately from 80 to 200°C and heat roll drying, and infrared ray drying. The coated layer may be crosslinked by irradiation with an electron beam for enhancing the water resistance and the curability

### Production Method of Gas-barrier Laminated Film for Organic Device

The gas-barrier laminated film for an organic device of the present invention contains the plural gas-barrier laminates laminated through an adhesive layer with the surface on the side of the substrate film of the gas-barrier laminate facing the surface on the side of the inorganic thin film layer thereof.
The gas-barrier laminated film for an organic device of the present invention contains plural plies of the gas-barrier laminates laminated, and from 2 to 10 plies of the gas-barrier laminates are preferably laminated, from 2 to 8 plies thereof are more preferably laminated, and from 2 to 4 plies thereof are further preferably laminated, from the standpoint of the productivity, the gas-barrier efficiency and the transparency.
Examples of the application method of the adhesive layer include a method of coating an adhesive on the surface of the gas-barrier laminate, and a method of laminating an adhesive film between the gas-barrier films.

In the present invention, an adhesive that forms an adhesive layer having gas-barrier property and an adhesive that suffers less occurrence of foreign matters and/or bubbles between the gas-barrier laminates, particularly in the adhesive layer, are preferably used. Preferred examples of the adhesive that hardly forms bubbles include an adhesive having an epoxy curing system. Preferred examples of the adhesive that forms an adhesive layer having gas-barrier property include an adhesive capable of imparting gas-barrier property to the adhesive layer owing to a large number of aromatic rings, such as a m-xylenediamine skeleton, a p-xylenediamine skeleton and a bisphenol skeleton, contained therein. An adhesive having an epoxy curing system using an epoxy resin is preferred since bubbles are prevented from occurring in the adhesive layer after forming the gas-barrier laminated film.
In the present invention, an adhesive containing an epoxy resin having at least one of a m-xylenediamine skeleton, a p-xylenediamine skeleton and a bisphenol skeleton is more preferred since excellent gas-barrier property is obtained, and foreign matters and/or bubbles hardly occur.

Examples of the adhesive having a curing system using an epoxy resin, which advantageously has gas-barrier property and hardly occurs bubbles, will be described below.
Examples of the adhesive include an epoxy resin having a glycidyl amine moiety derived from m-xylylenediamine, an epoxy resin having a glycidyl amine moiety derived from 1,3-bis(aminomethyl)cyclohexane, an epoxy resin having a glycidyl amine moiety derived from diaminodiphenylmethane, an epoxy resin having a glycidyl amine moiety derived from p-aminophenol, an epoxy resin having a glycidyl ether moiety derived from bisphenol A, an epoxy resin having a glycidyl ether moiety derived from bisphenol F, an epoxy resin having a glycidyl ether moiety derived from phenol novolak, and an epoxy resin having a glycidyl ether moiety derived from resorcinol. Among these, an epoxy resin having a glycidyl amine moiety derived from m-xylylenediamine and/or an epoxy resin having a glycidyl ether moiety derived from bisphenol F are preferred from the standpoint of the gas-barrier property.

Examples of a curing agent for the epoxy resin include a reaction product of (A) and (B) below and a reaction product of (A), (B) and (C) below.
(A) m-xylenediamine or p-xylenediamine
(B) a polyfunctional compound having at least one acyl group capable of forming an amide group moiety and an oligomer through reaction with polyamine
(C) a monobasic carboxylic acid having from 1 to 8 carbon atoms and/or a derivative thereof

Specific examples thereof include a reaction product of m-xylylenediamine or p-xylylenediamine, a modified reaction product thereof with an epoxy resin or a monoglycidyl compound formed therefrom, a modified reaction product thereof with an alkylene oxide having from 2 to 4 carbon atoms or an addition reaction product thereof with epichlorohydrin, with the polyfunctional compound having at least one acyl group capable of forming an amide group moiety and an oligomer through reaction with the polyamine, and a reaction product of the polyamine with the polyfunctional compound having at least one acyl group capable of forming an amide group moiety and an oligomer through reaction with the polyamine and the monobasic carboxylic acid having from 1 to 8 carbon atoms and/or a derivative thereof.

The viscosity of the adhesive may be controlled by the resin formulation of the adhesive composition, and also may be controlled by controlling the remaining solvent amount by the temperature and time upon coating the adhesive varnish, and in the case of a thermosetting resin, by controlling the semi-cured state of the thermosetting resin. The adhesive may be prepared by adding inorganic particles, such as crystalline silica, amorphous silica, aluminum hydroxide, alumina, aluminum nitride, boron nitride and antimony trioxide, or an organic particles, such as silicone powder. The inorganic particles and the organic particles may be used solely or as a combination of two or more kinds of them. Preferred examples of the inorganic particles include silica particles from the standpoint of the versatility and the stability

The average particle diameter of the inorganic particles and the organic particles is preferably from 0.005 to 50 µm, more preferably from 0.01 to 20 µm, and further preferably from 0.05 to 10 µm, from the standpoint of the hot water resistance and the cohesion failure resistance. The content of the inorganic particles and/or the organic particles in the adhesive is preferably from 0.01 to 30% by mass, and more preferably from 0.05 to 10% by mass, from the standpoint of the defoaming property and the adhesion strength.
The adhesive may appropriately contain, in addition to the component described above, such additives as a curing accelerator, a coupling agent, an inorganic ion absorbent and a polymerization initiator.
In the present invention, examples of the coating method of the adhesive include known methods using a reverse roll coater, a gravure coater, a rod coater, an air doctor coater, a spray coater or the like, and methods using a reverse roll coater and a gravure coater are preferred from the standpoint of the appearance of coating and the versatility.

The thickness of the adhesive layer is preferably from 0.2 to 30 µm, and more preferably from 0.5 to 10 µm, from the standpoint of the adhesion strength and the processability.
In the case where the adhesive film is used, the thickness of the adhesive film when the adhesive film is used solely is preferably from 1 to 100 µm, and more preferably from 5 to 50 µm, from the standpoint of the processability When a base film is used, the thickness of the base film is preferably 3 µm or more, and more preferably from 5 to 100 µm, from the barrier property, and the thickness in the state where the adhesive layers are formed on both surfaces of the base film is preferably from 6 to 160 µm, and more preferably approximately from 10 to 100 µm. The adhesive layers on both surfaces of the base film may be the same as or different from each other in thickness.

The adhesive film preferably has a low elastic modulus for reducing thermal stress caused by the difference in thermal expansion coefficient from the gas-barrier film, and the storage modulus thereof measured with a dynamic viscoelasticity measuring apparatus is preferably from 10 to 2,000 MPa at 25°C and from 3 to 50 MPa at 264°C.
Specific examples of the adhesive film include one formed of at least one selected from an epoxy resin, an epoxy group-containing acrylic copolymer, an epoxy resin curing agent and an epoxy thermosetting resin in a semi-cured state containing an epoxy resin, curing agent.

In the present invention, the surface roughness Rms of the adhesive layer or the adhesive film is preferably from 0.05 to 40 µm, more preferably from 0.10 to 20 µm, and particularly preferably from 0.2 to 20 µm, for facilitating deaeration of bubbles formed between the gas-barrier laminates upon curing. The surface roughness Rms can be attained, for example, by such methods as addition of inorganic particles or organic particles, mixing of two or more resins, and mechanical relief formation, and can be measured by the method described later.
Upon laminating the gas-barrier laminates, the surface on the side of the substrate film of the gas-barrier laminate is made to face the surface on the side of the inorganic thin film layer thereof, and from the standpoint of the processability, the gas-barrier laminates are preferably laminated with the adhesive layer (the adhesive or the adhesive film) provided on the surface of the inorganic thin film or the surface of the protective layer, which is provided depending on necessity, and are more preferably laminated by adhering the adhesive layer to the surface of the substrate of the gas-barrier laminate to be laminated.

In the gas-barrier laminated film of the present invention, the total number of foreign matters and/or bubbles having a maximum diameter of 0.5 mm or more is preferably 2 or less per 100 cm² between the gas-barrier laminates, particularly in the adhesive layer. The total number thereof is more preferably 1 or less, and further preferably 0.1 or less. The maximum diameter thereof can be observed with an optical microscope or the like. The foreign matters herein means resin powder, metal powder and the like. When the foreign matters entrain bubbles, the size of the bubbles is designated as the diameter.

The method for producing a gas-barrier laminated film of the present invention contains:
(1) a step of providing a gas-barrier laminate containing a substrate film having on at least one surface thereof at least two layers of inorganic thin film layers containing two or more inorganic thin film layers that are formed in contact with each other,
(2) a step of laminating the plural gas-barrier laminates with a surface on a side of the substrate film of the gas-barrier laminate facing a surface on a side of the inorganic thin film layer thereof, through an adhesive layer containing an epoxy adhesive having at least one of a m-xylenediamine skeleton, a p-xylenediamine skeleton and a bisphenol skeleton, to provide a gas-barrier laminated film, and
(3) a step of, after laminating or simultaneously with laminating the gas-barrier laminates in the step (2), heating the laminates in a vacuum atmosphere of 1,000 Pa or less, or radiating an active energy ray on the laminates.

The step (1) and the step (2) have been described above. The heating operation in a vacuum atmosphere in the step (3) is preferably performed at a temperature of from 30 to 250°C, more preferably from 50 to 200°C, and further preferably from 80 to 180°C, from the standpoint of the prevention of occurrence of bubbles between the gas-barrier film layers. The heating operation is preferably performed with application of pressure from the standpoint of the adhesion. The pressure to be applied is preferably from 1 to 50 kgf/cm², more preferably from 5 to 25 kgf/cm², and further preferably from 10 to 20 kgf/cm², in terms of surface pressure. The methods for heating and applying pressure are not particularly limited, and for example, the assembly is placed in a sealed mold, and the metal plates of the mold are externally heated to heat indirectly the assembly Examples of the method of indirectly heating include a method of heating by making a heater in contact with the outer surface of the metal plates, and a method of heating with a steam, a heated oil or the like in a jacket, which is a flow path for the heating medium provided on the metal plates. Examples of the methods include a method of applying a prescribed pressure to the mold, and then cooling the mold to provide the gas-barrier laminated film.
In the present invention, the heating operation is preferably performed in a vacuum atmosphere of 1,000 Pa or less from the standpoint of the decrease of bubbles and foreign matters and the time efficiency.

Examples of the energy ray include such active energy rays as visible light, an ultraviolet ray, an electron beam and a radiation ray, and among these, an ultraviolet ray and an electron beam are preferred from the standpoint of effective prevention of bubbles from occurring between the gas-barrier film layers. In the case where an ultraviolet ray is radiated as the active energy ray an ultraviolet ray lamp, such as a low-pressure mercury lamp, a high-pressure mercury lamp and a xenon lamp, and those having various light emission characteristics may be used without particular limitation, and can be controlled depending on the thickness of the films, the state of curing, and the like. The radiation energy of an ultraviolet ray is preferably from 100 to 5,000 mJ/cm², and particularly preferably from 1,000 to 3,000 mJ/cm². A radiation energy within the range performs sufficient curing of the resin layer and is also preferred from the standpoint of the productivity

The method of radiating an electron beam as the active energy ray for curing is preferred since no photoinitiator is required. The absorption dose of the electron beam is preferably from 1 to 200 kGy since curing of the resin layer sufficiently proceeds, and is more preferably from 5 to 100 kGy since curing sufficiently proceeds, and the plastic film and the resin layer are not damaged. When the absorption dose is in the range, curing of the sufficiently proceeds, and the plastic film and the resin layer are not damaged, thereby preventing the gas-barrier property from being impaired.
For radiating an electron beam as the active energy ray, any known apparatus may be used, and an electron beam with an acceleration voltage of from 1 to 200 kV is preferably radiated in consideration that damages of the plastic film and the resin layer due to the electron beam. When the acceleration voltage of the electron beam is in the range, a sufficient curing depth is obtained, and the mechanical properties of the substrate for the resulting gas-barrier film laminate are not lowered. The resin layer is preferably formed by radiating an electron beam of a low acceleration voltage of 100 kV or less, and particularly 50 kV or less since the mechanical strength of the substrate for the resulting gas-barrier film laminate is prevented from being lowered.

The aforementioned heating or active energy ray radiation is performed after laminating the gas-barrier laminates or simultaneously with laminating the gas-barrier laminates in the step (2), and is preferably performed after the lamination from the standpoint of the uniformity in curing
Examples of the organic device, to which the gas-barrier laminated film of the present invention is applied, include a display purpose, such as electronic paper, an organic EL illumination, and an organic solar cell, and the gas-barrier laminated film is preferably applied to a display purpose using an organic device owing to the gas-barrier property, the light transmittance, the less amounts of bubbles and foreign matters, and the flexibility.

### [Example]

The present invention will be described in more detail with reference to examples below, but the present invention is not limited to the examples.

### Evaluation Method

### (1) Water Vapor Permeability

The water vapor permeability was evaluated by the following manner according to the conditions of JIS Z0222 "test method of moisture permeability for moisture proof packing container" and JIS Z0208 "test method of moisture permeability for moisture proof package material (cup methods)".
Two plies of the gas-barrier laminated films each having a moisture permeation area of 10.0 cm × 10.0 cm were used, and a bag containing approximately 20 g of anhydrous calcium chloride as a moisture absorbent was produced by sealing the four edges of the films. The bag was placed in a constant temperature and constant humidity chamber at a temperature of 40°C and a relative humidity of 90%, and the mass of the bag was measured until the 200th day with an interval of 72 hours or more. The water vapor permeability was calculated from the gradient of the regression line of the elapsed time and the weight of the bag after the fourth day.

### (2) Number of Bubbles with Diameter of 0.5 mm or more between Gas-barrier Laminates (in Adhesive Layer)

The diameters of the bubbles were measured with a stereoscopic microscope. The number of bubbles was per 100 cm² was counted and evaluated for three specimens by the following four grades.
AA: number of bubbles of 1 or less per 100 cm²
A: number of bubbles of more than 1 and 2 or less per 100 cm²
B: number of bubbles of more than 2 and 10 or less per 100 cm²
C: number of bubbles of more than 10 per 100 cm²

### (3) Adhesion Strength between Films or Layers

According to JIS Z1707, the gas-barrier laminated film cut into a strip form with a width of 15 mm was partially peeled off at the end thereof, and peeled in a T-form at a speed of 300 mm//min with a peeling tester (Model Name EZ-TEST, produced by Shimadzu Corporation), thereby measuring the lamination strength (g per 15 mm).
Examples all had a sufficient strength of 700 g or more per 15 mm.

### (4) Vacuum Sealing

A base material having a structure of a polyethylene terephthalate film (H100C, produced by Mitsubishi Chemical Polyester Film Co., Ltd., thickness; 12 µm) / an unstretched polypropylene film (Pylen Film CT P1146, produced by Toyobo Co., Ltd., thickness: 100 µm) having been dry-laminated was prepared. Two plies of the base material cut into a size of 30 cm × 30 cm was superimposed on each other with the surfaces of the unstretched polypropylene films facing each other, and three edges thereof were heat-sealed with an impulse sealer, thereby preparing a vacuum packaging bag. The gas-barrier laminated film was placed in the resulting vacuum packaging bag, which was vacuum-sealed under vacuum of 10 Pa or less.

### (5) Measurement of Surface Roughness (Rms)

The surface of the gas-barrier film was measured with a scanning probe microscope (SPI 3800, produced by Seiko Instruments Inc.) in a non-contact mode (dynamic force mode). The scanning speed, the number of measured points per one measuring area, and the gradient correction were selected to such conditions that the surface state was clearly measured. The surface roughness (Rms) of the surface shape of the films was obtained by AREA Analysis of "CROSSSECTION", the attachment software of the scanning probe microscope SPI 3800.

### (6) Total Light Transmittance

The total light transmittance was measured by the transmission method with a haze meter (HDH 2000, produced by Nippon Denshoku Industries Co., Ltd.).

### (7) Measurement of Water Vapor Permeability of Gas-barrier Laminated Film

A urethane adhesive (a mixture of "AD900" and "CAT-RT85" produced by Toyo-Morton, Ltd. at a ratio of 10/1.5) was coated on the surface of the resulting gas-barrier laminated film on the side of the inorganic thin film, and dried to form an adhesive resin layer having a thickness of approximately 3 µm. An unstretched polypropylene film having a thickness of 60 µm (Pylen Film CT P1146, produced by produced by Toyobo Co., Ltd.) was laminated on the adhesive resin layer to provide a laminated film. The resulting laminated film was measured for water vapor permeability.
The water vapor permeability was measured according to the conditions of JIS Z0222 "test method of moisture Permeability for moisture proof packing container" and JIS Z0208 "test method of moisture permeability for moisture proof package material (cup method)".

### Example 1

polyethylene terephthalate resin (hereinafter abbreviated as "PET", "Novapex" produced by Mitsubishi Chemical Corporation) was melt-extruded to form a sheet, which was stretched in the longitudinal direction at a stretching temperature of 95°C and a stretching ratio of 3.3 and then stretched in the transversal direction at a stretching temperature of 110°C and a stretching ratio of 3.3, thereby providing a biaxially stretched PET film having a thickness of 12 µm, A mixture of an isocyanate compound ("Coronate L" produced by Nippon Polyurethane Co., Ltd.) and a saturated polyester ("Vylon 300" produced by Toyobo Co., Ltd., number average molecular weight: 23,000) mixed at a mass ratio of 1/1 was coated on one surface of the resulting film and dried to form an anchor coating (AC) layer having a thickness of 100 nm.
SiO was evaporated by high-frequency heating in vacuum of 1.33 × 10⁻⁸ Pa (1 × 10⁻⁵ Torr) and deposited on the anchor coating layer with a vacuum vapor deposition apparatus, thereby forming an inorganic thin film having a thickness of approximately 20 nm.
On the resulting inorganic thin film as the first layer, a silicon compound film (SiOₓN_{y}, x: 1.5, y: 0.4) having a thickness of approximately 30 nm was formed as the second layer of the inorganic thin film in the following manner, thereby providing a gas-barrier laminate. A catalytic chemical vapor deposition (Cat-CVD) apparatus was used, in which the distance of the heating catalyst body was 20 cm, the substrate temperature before accumulation was 10°C, the material of the heating catalyst body was tungsten with a dimension of 0.5 mm in diameter × 2,650 mm, and the temperature of the heating catalyst body was 1,750°C. Thereafter, the silicon compound film as the second layer was formed in such manner that monosilane gas (SiH₄), oxygen gas (O₂), ammonia gas (NHa) and hydrogen gas (H₂) were introduced at a mixing ratio of 1/0.7/2.2/40, and were subjected to contact thermal decomposition in vacuum of 20.0 Pa (0.15 Torr) at a film forming rate of 10 nm/min.

An adhesive was produced in such a manner that a methanol/ethyl acetate = 1/1 solution (solid concentration: 30% by weight) containing 50 parts by weight of an epoxy resin having a glycidyl amine moiety derived from m-xylylenediamine (TETRAD-X, produced by Mitsubishi Gas Chemical Co., Inc.) and 89 parts by weight of an epoxy resin curing agent (A), to which 0.02 part by weight of an acrylic moistening agent (BYK 381, produced by BYK Chemie Co., Ltd.) was added, followed by well stirring. The adhesive was coated on the surface of the inorganic thin film of the gas-barrier laminate to form a thermosetting adhesive layer having a thickness of approximately 3 µm after drying and a surface roughness (Rms) of 0.20 µm. The gas-barrier laminate having the adhesive layer was cut into a size of 12 cm × 12 cm, and three plies of the gas-barrier laminates were superimposed on each other with the adhesive layer facing the surface of the PET film of the substrate film. On the outermost adhesive layer, a biaxially stretched polyester film having a thickness of 12 µm cut into a size of 12 cm × 12 cm was superimposed. The resulting assembly was packed in vacuum at 10 Pa in the aforementioned manner. The gas-barrier film having been packed in vacuum was heated in an oven at 120°C under the atmospheric pressure for 30 minutes to melt-adhere the adhesive layers, thereby providing a gas-barrier laminated film. The resulting gas-barrier laminated film was subjected to the aforementioned evaluation. The results are shown in Table 1.

The composition of the silicon compound film was measured with an X-ray photoelectron spectrometer (Model Name ESCA-3400, produced by Shimadzu Corporation), which was the same as in the following examples.
The substrate temperature after completing accumulation was 65°C or less.

### Example 2

A gas-barrier laminated film was produced and evaluated in the same manner as in Example 1 except that the order of the first layer and the second layer of the inorganic thin films were inverted. The results are shown in Table 1.

### Example 3

A polyethylene terephthalate resin (hereinafter abbreviated as "PET", "Novapex" produced by Mitsubishi Chemical Corporation) was melt-extruded to form a sheet, which was stretched in the longitudinal direction at a stretching temperature of 95°C and a stretching ratio of 3.3 and then stretched in the transversal direction at a stretching temperature of 110°C and a stretching ratio of 3.3, thereby providing a biaxially stretched PET film having a thickness of 12 µm. A mixture of an isocyanate compound ("Coronate L" produced by Nippon Polyurethane Co., Ltd.) and a saturated polyester ("Vylon 300" produced by Toyobo Co., Ltd., number average molecular weight: 23,000) mixed at a mass ratio of 1/1 was coated on one surface of the resulting film and dried to form an anchor coating (AC) layer having a thickness of 100 nm.
The first layer of an inorganic thin film of ZnSnOₓ having a thickness of approximately 20 nm was formed on the anchor coating layer with a sputtering apparatus. SiO was evaporated by high-frequency heating in vacuum of 1 × 10⁻⁵ Torr and deposited on the first layer of the inorganic thin film with a vacuum vapor deposition apparatus, thereby forming an inorganic thin film having a thickness of approximately 20 nm. A gas-barrier laminate was produced and evaluated in the same manner as in Example 1 except for the above. The results are shown in Table 1.

### Example 4

A gas-barrier laminated film was produced and evaluated in the same manner as in Example 1 except that SiO was evaporated by high-frequency heating in vacuum of 1.33 × 10⁻³ Pa (1 × 10⁻⁵ Torr) and deposited on the surface of the inorganic thin film as the second layer with a vacuum vapor deposition apparatus, thereby forming an inorganic thin film having a thickness of approximately 20 nm. The results are shown in Table 1.

### Example 5

A gas-barrier laminated film was produced and evaluated in the same manner as in Example 4 except that an inorganic thin film of ZnSnOₓ having a thickness of approximately 20 nm was formed as the second layer of the inorganic thin film with a sputtering apparatus. The results are shown in Table 1.

### Example 6

A gas-barrier laminated film was produced and evaluated in the same manner as in Example 4 except that a composite SiON layer of silicon nitride and silicon oxide (ratio of silicon nitride and silicon oxide: 8/2) having a thickness of 10 nm was formed as the second layer of the inorganic thin film in such a manner that monosilane, oxygen, ammonia and hydrogen as raw material gas were fed, and a prescribed electric power was applied under vacuum by a plasma CVD method, thereby accumulating the film. The results are shown in Table 1.

### Example 7

A gas-barrier laminated film was produced and evaluated in the same manner as in Example 4 except that an inorganic film as the fourth layer was formed on the third layer of the inorganic thin film in the same production method as the second layer, and an inorganic films as the fifth layer was formed thereon in the same production method as the third layer. The results are shown in Table 1.

### Example 8

A. gas-barrier laminated film was produced and evaluated in the same manner as in Example 1 except that two plies of the gas-barrier laminates were superimposed on each other. The results are shown in Table 1.

### Example 9

A gas-barrier laminated film was produced and evaluated in the same manner as in Example 2 except that two plies of the gas-barrier laminates were superimposed on each other. The results are shown in Table 1.

### Example 10

A gas-barrier laminated film was produced and evaluated in the same manner as in Example 4 except that two plies of the gas-barrier laminates were superimposed on each other. The results are shown in Table 1.

### Example 11

A gas-barrier laminated film was produced and evaluated in the same manner as in Example 5 except that two plies of the gas-barrier laminates were superimposed on each other. The results are shown in Table 1.

### Example 12

A gas-barrier laminated film was produced and evaluated in the same manner as in Example 7 except that two plies of the gas-barrier laminates were superimposed on each other. The results are shown in Table 1.

### Comparative Example 1

A PET resin ("Novapex" produced by Mitsubishi Chemical Corporation) was melt-extruded to form a sheet, which was stretched in the longitudinal direction at a stretching temperature of 95°C and a stretching ratio of 3.3 and then stretched in the transversal direction at a stretching temperature of 110°C and a stretching ratio of 3.3, thereby providing a biaxially stretched PET film having a thickness of 12 µm. A mixture of an isocyanate compound ("Coronate L" produced by Nippon Polyurethane Co., Ltd.) and a saturated polyester ("Vylon 300" produced by Toyobo Co., Ltd., number average molecular weight: 23,000) mixed at a mass ratio of 1/1 was coated on one surface of the resulting film and dried to form an anchor coating (AC) layer having a thickness of 100 nm.

SiO was evaporated by high-frequency heating in vacuum of 1.33 × 10⁻³ Pa (1 × 10⁻⁵ Torr) and deposited on the anchor coating layer with a vacuum vapor deposition apparatus, thereby forming an inorganic thin film having a thickness of approximately 20 nm, and thus a gas-barrier laminate was produced.

An adhesive was produced in such a manner that a methanol/ethyl acetate = 1/1 solution (solid concentration: 30% by weight) containing 50 parts by weight of an epoxy resin having a glycidyl amine moiety derived from m-xylylenediamine (TETRAD-X, produced by Mitsubishi Gas Chemical Co., Inc.) and 89 parts by weight of an epoxy resin curing agent (A), to which 0.02 part by weight of an acrylic moistening agent (BYK 381, produced by BYK Chemie Co., Ltd.) was added, followed by well stirring. The adhesive was coated on the surface of the inorganic thin film of the gas-barrier laminate to form a thermosetting adhesive layer having a thickness of approximately 3 µm after drying and a surface roughness (Rms) of 0.20 µm. The gas-barrier laminate having the adhesive layer was cut into a size of 12 cm × 12 cm, and three plies of the gas-barrier laminates were superimposed on each other with the adhesive layer facing the surface of the PET film. On the outermost adhesive layer, a biaxially stretched polyester film having a thickness of 12 µm cut into a size of 12 cm x 12 cm was superimposed. The resulting assembly was packed in vacuum at 10 Pa in the aforementioned manner. The gas-barrier laminated film having been packed in vacuum was heated in an oven at 120°C under the atmospheric pressure for 30 minutes to melt-adhere the adhesive layers, thereby providing a gas-barrier laminated film. The resulting gas-barrier laminated film was subjected to the aforementioned evaluation. The results are shown in Table 1.

### Comparative Example 2

A PET resin ("Novapex" produced by Mitsubishi Chemical Corporation) was melt-extruded to form a sheet, which was stretched in the longitudinal direction at a stretching temperature of 95°C and a stretching ratio of 3.3 and then stretched in the transversal direction at a stretching temperature of 110° C and a stretching ratio of 3.3, thereby providing a biaxially stretched PET film having a thickness of 12 µm. A mixture of an isocyanate compound ("Coronate L" produced by Nippon Polyurethane Co., Ltd.) and a saturated polyester ("Vylon 300" produced by Toyobo Co., Ltd., number average molecular weight: 23,000) mixed at a mass ratio of 1/1 was coated on one surface of the resulting film and dried to form an anchor coating (AC) layer having a thickness of 100 nm.
SiO was evaporated by high-frequency heating in vacuum of 1.33 × 10⁻³ Pa (1 × 10⁻⁵ Torr) and deposited on the anchor coating layer with a vacuum vapor deposition apparatus, thereby forming an inorganic thin film having a thickness of approximately 20 nm, and thus a gas-barrier laminate was produced.
A mixture of an isocyanate compound ("Coronate L" produced by Nippon Polyurethane Co., Ltd.) and a saturated polyester ("Vylon 300" produced by Toyobo Co., Ltd.) mixed at a mass ratio of 1/1, to which 5% by mass of a silane coupling agent (SH6040, produced by Toray Dow Coming Co., Ltd.) was added, was coated on the surface of inorganic thin film of the resulting inorganic thin film, and dried to form a resin layer having a thickness of 0.5 nm.

SiO was evaporated by high-frequency heating in vacuum of 1.33 × 10⁻³ Pa (1 × 10⁻⁵ Torr) and deposited on the resin layer with a vacuum vapor deposition apparatus, thereby forming an inorganic thin film having a thickness of approximately 20 nm, and thus a gas-barrier laminate was produced.
A two-component type polyurethane adhesive containing a polyester polyol and a polyisocyanate was coated on the surface of the inorganic thin film of the gas-barrier laminate to form a thermosetting adhesive layer having a thickness of approximately 3 µm after drying and a surface roughness (Rms) of 0.20 µm. The gas-barrier laminate having the adhesive layer was cut into a size of 12 cm × 12 cm, and three plies of the gas-barrier laminates were superimposed on each other with the adhesive layer facing the surface of the PET film. On the outermost adhesive layer, a biaxially stretched polyester film having a thickness of 12 µm cut into a size of 12 cm × 12 cm was superimposed. The resulting assembly was packed in vacuum at 10 Pa in the aforementioned manner. The gas-barrier laminated film having been packed in vacuum was heated in an oven at 120°C under the atmospheric pressure for 30 minutes to melt-adhere the adhesive layers, thereby providing a gas-barrier laminated film. The resulting gas-barrier laminated film was subjected to the aforementioned evaluation. The results are shown in Table 1.

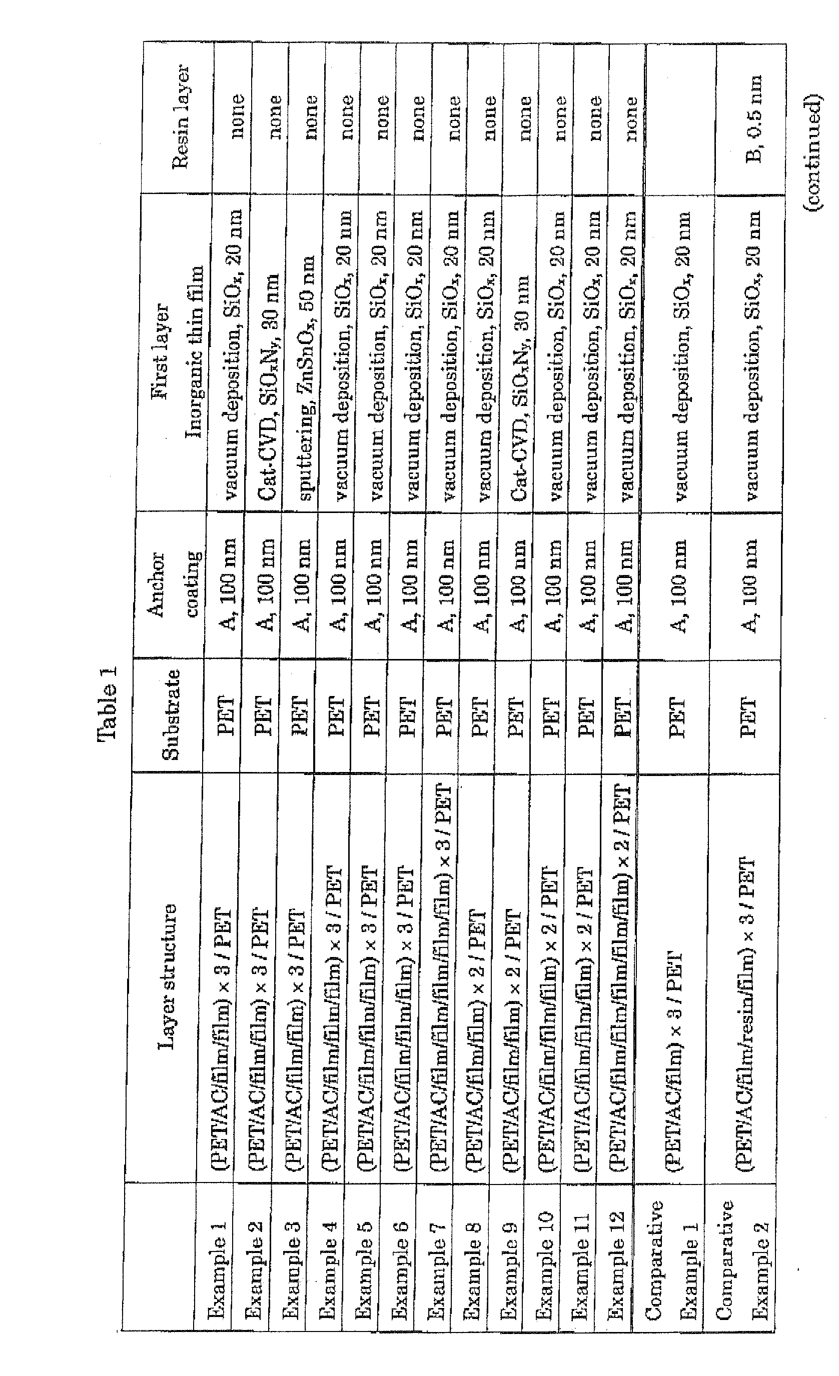

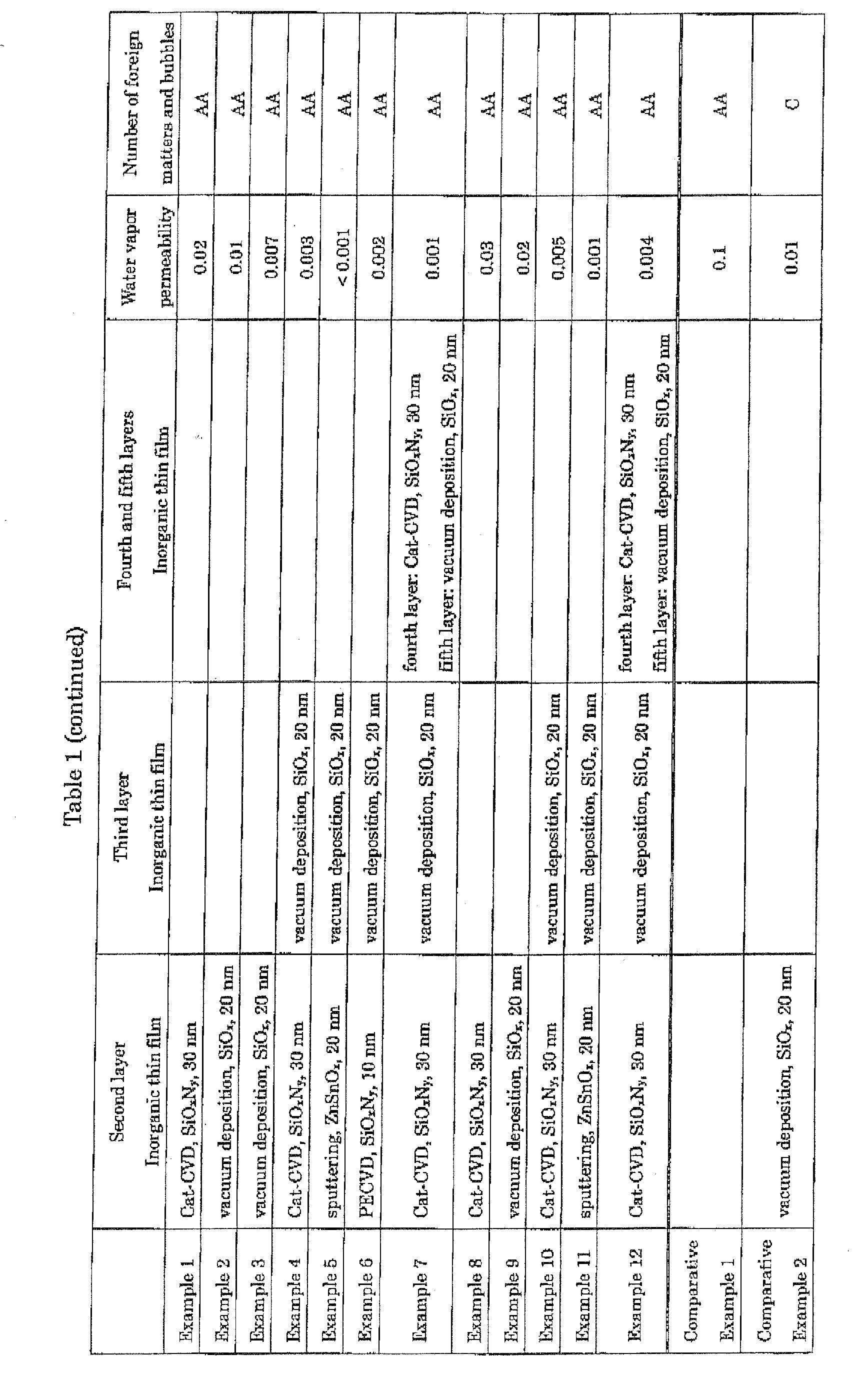

### [Industrial Applicability]

According to the present invention, a laminated film that exhibits considerably excellent gas-barrier property and has excellent adhesion strength among the constitutional layers is provided, which is very useful as a film for an organic device owing to considerably decreased occurrence of bubbles and foreign matters between the gas-barrier film layers.

## Claims

1. A gas-barrier laminated film for an organic device, comprising a plurality of gas-barrier laminates each containing a substrate film having on at least one surface thereof at least two layers of inorganic thin film layers, the plurality of gas-barrier laminates being laminated through an adhesive layer, wherein the at least two layers of inorganic thin film layers contain two or more inorganic thin film layers that are formed in contact with each other, the gas-barrier laminates are laminated with a surface on a side of the substrate film of the gas-barrier laminate facing a surface on a side of the inorganic thin film layer thereof, and the adhesive layer contains an epoxy adhesive having at least one of a m-xylenediamine skeleton, a p-xylenediamine skeleton and a bisphenol skeleton.

2. The gas-barrier laminated film for an organic device according to claim 1, wherein a total number of foreign matters and/or bubbles having a maximum diameter of 0.5 mm or more is 2 or less per 100 cm² in the adhesive layer.

3. The gas-barrier laminated film for an organic device according to claim 1, further comprising an anchor coating layer on the substrate film of the gas-barrier laminate.

4. The gas-barrier laminated film for an organic device according to claim 1, wherein the at least two layers of inorganic thin film layers contain only two or more inorganic thin film layers that are formed in contact with each other.

5. The gas-barrier laminated film for an organic device according to claim 1, wherein the at least two layers of inorganic thin film layers contain from 2 to 5 layers.

6. The gas-barrier laminated film for an organic device according to claim 1, wherein the plurality of gas-barrier laminates contains from 2 to 10 plies thereof.

7. A method for producing a gas-barrier laminated film for an organic device, comprising:
(1) a step of providing a gas-barrier laminate containing a substrate film having on at least one surface thereof at least two layers of inorganic thin film layers containing two or more inorganic thin film layers that are formed in contact with each other,
(2) a step of laminating the plural gas-barrier laminates with a surface on a side of the substrate film of the gas-barrier laminate facing a surface on a side of the inorganic thin film layer thereof, through an adhesive layer containing an epoxy adhesive having at least one of a m-xylenediamine skeleton, a p-xylenediamine skeleton and a bisphenol skeleton, to provide a gas-barrier laminated film, and
(3) a step of, after laminating or simultaneously with laminating the gas-barrier laminates in the step (2), heating the laminates in a vacuum atmosphere of 1,000 Pa or less, or radiating an active energy ray on the laminates.
